(19) Europäisches Patentamt
European Patent Office
Office européen des brevets

(11) **EP 3 830 030 B1**

(12) **EUROPÄISCHE PATENTSCHRIFT**

(45) Veröffentlichungstag und Bekanntmachung des Hinweises auf die Patenterteilung:
**14.06.2023   Patentblatt 2023/24**

(21) Anmeldenummer: **18756375.4**

(22) Anmeldetag: **27.07.2018**

(51) Internationale Patentklassifikation (IPC):
*C01B 33/035* (2006.01)   *C23C 16/458* (2006.01)
*C23C 16/24* (2006.01)   *C23C 16/44* (2006.01)

(52) Gemeinsame Patentklassifikation (CPC):
**C01B 33/035; C23C 16/24; C23C 16/4418; C23C 16/4581**

(86) Internationale Anmeldenummer:
**PCT/EP2018/070466**

(87) Internationale Veröffentlichungsnummer:
**WO 2020/020468 (30.01.2020 Gazette 2020/05)**

(54) **ELEKTRODE ZUM ABSCHEIDEN VON POLYKRISTALLINEM SILICIUM**

ELECTRODE FOR DEPOSITING POLYCRYSTALLINE SILICON

ÉLECTRODE POUR DÉPOSER DU SILICIUM POLYCRISTALLIN

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**09.06.2021   Patentblatt 2021/23**

(73) Patentinhaber: **Wacker Chemie AG**
**81737 München (DE)**

(72) Erfinder:
• **KRAUS, Heinz**
**84367 Zeilarn (DE)**
• **FILAR, Piotr**
**84533 Marktl (DE)**

(74) Vertreter: **Belz, Ferdinand et al**
**Wacker Chemie AG**
**Hanns-Seidel-Platz 4**
**81737 München (DE)**

(56) Entgegenhaltungen:
**WO-A1-2010/133386    WO-A1-2016/073014**
**CN-U- 204 938 991    DE-U1-202013 104 065**

**Beschreibung**

Die Erfindung betrifft eine Elektrode mit einem Haltesegment, einem Basissegment, das eine Auslassung aufweist, in welcher das Haltesegment aufgenommen ist, und ggf. mindestens einem Zwischensegment, das zwischen dem Basissegment und dem Haltesegment angeordnet ist, wobei sich zumindest zwei der Segmente hinsichtlich ihrer spezifischen Wärmeleitfähigkeit unterscheiden, wobei das Haltesegment die niedrigste und das Basissegment die höchste spezifische Wärmeleitfähigkeit aufweist. Benachbarte Segmente weisen ferner einander gegenüberliegende Grenzflächen auf, die zumindest teilweise mechanisch miteinander in Kontakt stehen und so mindestens eine gemeinsame Kontaktfläche bilden.

Elektroden, insbesondere Graphitelektroden, sind ein wichtiger Bestandteil bei industriellen Verfahren, beispielsweise Aluminium- und Stahlgewinnung, Elektrolyse von Salzschmelzen, elektrolytische Zersetzung von chemischen Verbindungen, thermische Abscheidereaktionen und Lichtbogenschweißen.

Eine wichtige Anwendung aus dem Bereich der thermischen Abscheidereaktionen ist die Herstellung von polykristallinem Silicium (Polysilicium) nach dem Siemens-Verfahren. Dabei werden in einem glockenförmigen Reaktor Filamentstäbe (Dünnstäbe) aus Silicium durch direkten Stromdurchgang erhitzt und ein Reaktionsgas, enthaltend eine siliciumhaltige Komponente, und Wasserstoff eingeleitet. Die siliciumhaltige Komponente ist gewöhnlich Monosilan oder ein Halogensilan der allgemeinen Zusammensetzung $SiH_nX_{4-n}$ (n = 0, 1, 2, 3; X = Cl, Br, I). Üblicherweise handelt es sich um ein Chlorsilan oder Chlorsilangemisch, meist um Trichlorsilan. Der Aufbau eines typischen Siemens-Reaktors ist beispielsweise in der US 2009/0136408 A1 beschrieben.

Der Reaktorboden ist grundsätzlich mit mehreren Elektrodenhalterungen versehen, wobei die Elektrodenhalterungen den Reaktorboden elektrisch isoliert durchdringen und mit einem verdickten Ende, dem Kopf der Elektrodenhalterung, in den Reaktor ragen. Die Durchführung der Elektrodenhalterung wird meist mit einem Dichtungselement abgedichtet. Der Kopf der Elektrodenhalterung hat für gewöhnlich eine Auslassung, in welche eine Elektrode formschlüssig eingesteckt wird. Die Elektrodenhalterung besteht üblicherweise aus einem Material, das elektrisch leitfähig ist, beispielsweise aus einem Metall.

Die Elektrode kann in der Regel einen Filamentstab aufnehmen und in Position halten. Die Elektroden bestehen üblicherweise aus hochreinem Graphit. Hochreiner Graphit hat einen Rückstand bei Kaltveraschung von < 50 ppm. Zwei Filamentstäbe sind meist durch eine Brücke (aus demselben Material wie die Filamentstäbe) zu einem Paar verbunden, das über die Elektrodenhalterungen und Elektroden einen Stromkreis bildet (Filamentstabpaar). Über die unterhalb des Reaktorbodens angeordneten Enden der Elektrodenhalterungen wird elektrische Energie zur Beheizung der Filamentstäbe zugeführt. Die Oberflächentemperatur der Filamentstäbe beträgt gewöhnlich mehr als 1000°C. Bei diesen Temperaturen zersetzt sich die siliciumhaltige Komponente und elementares Silicium scheidet sich aus der Gasphase als Polysilicium auf der Staboberfläche ab. Dadurch nimmt der Durchmesser der Dünnstäbe zu. Die Elektrode wird dabei für gewöhnlich zumindest teilweise umschlossen. Nach dem Erreichen eines vorgegebenen Durchmessers wird die Abscheidung gestoppt und die erhaltenen Stabpaare ausgebaut. Nach dem Entfernen der Brücke werden annähernd zylinderförmige Polysiliciumstäbe erhalten.

Die Elektroden dienen also als Befestigung für die Filamentstäbe, der Übertragung des Stromflusses und der dadurch generierten Wärme in den Filament- bzw. Polysiliciumstab sowie insbesondere als Halterung für die anwachsenden, immer schwerer werdenden Polysiliciumstäbe. Je nach Zieldurchmesser und Länge der abzuscheidenden Polysiliciumstäbe können Stabgewichte von 50 bis 400 kg/Stab erreicht werden. Des Weiteren wird über die Elektroden Wärmeenergie vom unteren Ende der Polysiliciumstäbe zu den in der Regel gekühlten Elektrodenhalterungen abgeführt. Die Wahl der Form und des Materials der Elektrode ist daher von grundlegender Bedeutung.

Üblicherweise wird Graphit als Elektrodenmaterial verwendet, da Graphit in sehr hoher Reinheit herstellbar und auch bei Temperaturen oberhalb von 1200°C chemisch inert ist. Weiterhin hat Graphit einen sehr geringen spezifischen elektrischen Widerstand im Bereich zwischen 5 und 50 p2*m.

Eine Graphitelektrode mit einer herkömmlichen Form ist beispielsweise in der US 6,639,192 B2 beschrieben. Sie besteht aus einem zylindrischen Grundkörper mit einer kegelförmigen Spitze. Die Spitze enthält eine Bohrung zur Aufnahme und Kontaktierung eines Filamentstabs. Die Elektrode ist einstückig aus Graphit ausgebildet, wobei der verwendete Graphittyp meist eine hohe spezifische Wärmeleitfähigkeit von > 145 W/m*K hat. Nachteilig ist, dass eine solche Elektrode bei einem geringen Stabdurchmesser aufgrund der zylindrischen Form und der hohen spezifischen Wärmeleitfähigkeit eine hohe Wärmeableitung zeigt.

Um einem Umfallen dünner Polysiliciumstäbe zu Beginn der Abscheidung entgegenzuwirken, sollte eine Elektrode eine möglichst geringe Wärmeableitung zeigen. Dazu ist ein Elektrodenwerkstoff mit niedriger spezifischer Wärmeleitfähigkeit und/oder eine Elektrode mit geringem Durchmesser notwendig. Um dagegen einem Umfallen dicker Polysiliciumstäbe gegen Ende der Abscheidung entgegenzuwirken, sollte die Elektrode grundsätzlich sowohl eine möglichst große Wärmeleitfähigkeit, also aus einem Material mit möglichst hoher spezifischer Wärmeleitfähigkeit bestehen und/oder einen großen Durchmesser aufweisen. Die für die Erzeugung großer Stabdurchmesser notwendige Energie kann so besser abgeleitet zu können. Weiterhin benötigen die Elektroden zur Aufnahme der hohen Stabgewichte mechanische Stabilität, also einen vom Stabgewicht abhängigen Mindestdurchmesser.

Unter dünnen Stäben können im Allgemeinen Stabdurchmesser von weniger als dem 1,5-fachen, unter dicken Stäben von mehr als dem 1,5-fachen des Durchmessers einer Graphitelektrode verstanden werden.

Ein Verbesserung stellt die in der US 9,150,420 B2 beschriebene Kohlenstoffelektrode dar, die neben einer kegelförmigen Spitze einen diese umgebeneden Rand aufweist. Es hat sich gezeigt, dass eine solche Elektrode eine verbesserte Wärmeableitung und Verteilung der Stromdichte in Relation zur Stabdicke aufweist.

Allerdings stößt auch diese Elektrode angesichts der Forderung nach immer leistungsfähigeren Abscheideprozessen, die möglichst große Stabdurchmesser liefern sollen, in Kombination mit der Forderung nach sehr geringeren bis keinen Umfallzahlen, an ihre Grenzen.

In der US 8,366,892 B2 ist eine Graphitelektrode aus zwei Komponenten beschrieben. Diese besteht aus einem Basiselement und einem Einsatz, wobei der Einsatz im Basiselement steckt und beide aus verschiedenen Graphitsorten bestehen. Die Graphitsorte des Einsatzes weist eine niedrigere spezifische Wärmeleitfähigkeit als die Graphitsorte des Basiselements auf. Dadurch wird dem Bedarf nach einer möglichst geringen Wärmeleitfähigkeit zu Beginn der Abscheidung sowie dem Bedarf einer möglichst großen Wärmeleitfähigkeit gegen Ende der Abscheidung Rechnung getragen.

WO 2010/133386 A1 beschreibt einen Aufnahmekegel aus Graphit, wobei der Aufnahmekegel aus einem rotationssymmetrischen Grundkörper und einem zentrisch in diesen einsetzbares Spannelement besteht. Das Spannelement dient der Aufnahme des Filamentstabs und ist mit Schlitzen versehen, die das Einspannen des Filamentstabs ermöglichen.

DE 20 2013 104065 U1 offenbart eine Halterung für einen Filamentstab, umfassend ein Spannelement, in welches der Stab eingesteckt wird. Ein Adapter vermittelt den Kontakt zwischen dem Spannelement und einer Stromdurchführung. Das Spannelement ist an seiner Unterseite mit einer Vertiefung versehen.

WO 2016/073014 A1 beschreibt eine Halterung für einen Filamentstab, die ein auf einem Spannfutterträger angeordnetes Spannfutterelement umfasst, wobei zwischen Spannfutterträger und Spannfutterelement ein Hohlraum ausgebildet ist. Das Spannfutterelement weist eine Aufnahme für den Filamentstab auf.

CN 204 938 991 U beschreibt eine Halterung aus Graphit, die aus einer konisch zulaufenden Aufnahme für den Filamentstab und einem die Aufnahme tragenden Stützelement besteht. Die Aufnahme und das Stützelement sind von einer entfernbaren Kappe eingehaust.

Problematisch ist allerdings, dass bei Graphit die spezifische Wärmeleitfähigkeit minimal ca. 30 W/m*K betragen kann. Eine insbesondere zu Beginn der Abscheidung wünschenswerte noch geringere Wärmeleitfähigkeit zur weiteren Prozessoptimierung ist grundsätzlich nicht realisierbar. Es könnte zwar der Durchmesser der Elektrode verringert werden, allerdings träten dann die bereits beschriebenen Probleme mit fortschreitender Abscheidezeit auf.

Der Erfindung lag die Aufgabe zugrunde, eine Elektrode bereitzustellen, bei der die beschriebenen Probleme nicht auftreten oder zumindest deutlich reduziert sind.

Diese Aufgabe wird gelöst durch eine Elektrode mit einem Haltesegment, einem Basissegment, das eine Auslassung aufweist, in welcher das Haltesegment aufgenommen ist, und optional mindestens einem Zwischensegment, das zwischen dem Basissegment und dem Haltesegment angeordnet ist, wobei benachbarte Segmente einander gegenüberliegende Grenzflächen aufweisen, die zumindest teilweise mechanisch miteinander in Kontakt stehen und so eine gemeinsame Kontaktfläche bilden. Zur Verringerung der Kontaktfläche weist zumindest eine der Grenzflächen mindestens eine Vertiefung und/oder Erhebung auf.

Die Kontaktfläche entspricht also der mechanischen Kontaktfläche zwischen den Segmenten und gewährleistet sowohl thermische als auch elektrische Leitfähigkeit.

Umfasst die Elektrode beispielsweise nur ein Basis- und ein Haltesegment, bildet sich die Kontaktfläche aus den einander gegenüberliegenden Grenzflächen des Basis- und des Haltesegments. Die dem Haltesegment gegenüberliegende Grenzfläche des Basissegments kann der Oberfläche der Auslassung entsprechen. Umfasst die Elektrode beispielsweise noch ein Zwischensegment, wird die Kontaktfläche einerseits aus den einander gegenüberliegenden Grenzflächen des Basis- und des Zwischensegments, andererseits aus den einander gegenüberliegenden Grenzflächen des Zwischen- und des Haltesegments gebildet.

Durch die Verringerung der Kontaktfläche wird die Wärmeabfuhr vom Haltesegment hin zum Basissegment reduziert. Die Wärmeleitfähigkeit des Haltesegments kann so im Prinzip auf weniger als die minimale spezifische Wärmeleitfähigkeit von Graphit (ca. 30 W/m*K) reduziert werden. Dabei hat sich gezeigt, dass die Stabilität und strukturelle Integrität der Elektrode durch die Vertiefungen bzw. Erhebungen an zumindest einer der Grenzflächen erhalten bleibt.

Vorzugsweise entspricht die durch die Vertiefungen und/oder Erhebungen reduzierte Kontaktfläche 10 bis 90 %, bevorzugt 30 bis 90 %, besonders bevorzugt 60 bis 90 %, der Kontaktfläche, die sich ohne das Vorhandensein der Vertiefungen und/oder Erhebungen ergeben würde.

Bevorzugt sind die Segmente ineinandergesteckt und insbesondere koaxial ausgebildet, weisen also eine gemeinsame Rotationsachse auf. Die Geometrie der Segmente kann jedoch grundsätzlich beliebig gewählt werden, wobei eine zylindrische Ausführung bevorzugt ist (unbeachtlich ggf. vorhandener Vertiefungen und/oder Erhebungen). Die Segmente müssen allerdings nicht notwendigerweise alle dieselbe Geometrie aufweisen. Bezüglich möglicher Geometrien der Elektrode kann insbesondere auch auf die US 9,150,420 B2 verwiesen werden.

Die Auslassung zur Aufnahme des Haltesegments ist vorzugsweise zylindrisch ausgebildet, beispielsweise handelt es ich um eine Bohrung. Ein ggf. vorhandenes Zwischensegment weist vorzugsweise ebenfalls eine Auslassung, vorzugsweise Bohrung, entweder zur Aufnahme eines weiteren Zwischensegments oder zur Aufnahme des Haltesegments auf. Die Geometrien der Auslassungen sind grundsätzlich ebenfalls beliebig wählbar und können sich untereinander unterscheiden.

Vorzugsweise handelt es sich bei der Elektrode um eine 2-Segmentelektrode aus einem Basis- und einem Haltesegment oder um eine 3-Segmentelektrode mit ferner einem Zwischensegment.

Ferner ist es bevorzugt, dass zumindest oder ausschließlich die Grenzfläche des Haltesegments zumindest eine Vertiefung und/ oder Erhebung aufweist.

Die Segmente bestehen bevorzugt aus Kohlenstoff, besonders bevorzugt aus Graphit, insbesondere aus hoch- oder höchstreinem Graphit. Hochreiner Graphit hat ein Rückstand nach Kaltveraschung von < 50 ppm. Höchstreiner Graphit hat ein Rückstand nach Kaltveraschung von < 10 ppm. Das Haltesegment kann auch aus kohlenstofffaserverstärkten Kohlenstoffen (CFC) bestehen. Aus Gründen der Reinheit ist höchstreiner Graphit bevorzugt.

Zumindest zwei der Segmente unterscheiden sich hinsichtlich ihrer spezifischen Wärmeleitfähigkeit, wobei das Haltesegment die niedrigste und das Basissegment die höchste spezifische Wärmleitfähigkeit aufweisen. Die spezifische Wärmleitfähigkeit nimmt also vom Zentrum der Elektrode (Haltesegment) hin zu ihrem Rand (Basissegment) zu.

Die spezifische Wärmeleitfähigkeit des Haltesegments liegt bevorzugt zwischen 10 und 120 W/m*K, besonders bevorzugt zwischen 10 und 90 W/m*K, insbesondere zwischen 10 und 60 W/m*K.

Die spezifische Wärmeleitfähigkeit des Basissegments liegt bevorzugt zwischen 40 und 200 W/m*K, besonders bevorzugt zwischen 60 und 120 W/m*K, insbesondere zwischen 60 und 100 W/m*K.

Die spezifische Wärmeleitfähigkeit eines ggf. vorhandenen Zwischensegments, liegt in der Regel zwischen den für das Halte- und Basissegment angegebenen Werten. Das Zwischensegment kann jedoch auch dieselbe Wärmekapizität wie das Halte- oder das Basissegment aufweisen.

Alle Werte der spezifischen Wärmeleitfähigkeiten beziehen sich auf eine Temperatur von 20°C und werden gemäß DIN 51908 gemessen.

Bezüglich weiterer Eigenschaften des für die Segmente bevorzugt verwendeten Kohlenstoffmaterials kann auf die US 9,150,420 B2 verwiesen werden.

Die Vertiefung und/oder Erhebung sind vorzugsweise punktförmig und/oder linienförmig ausgebildet und können grundsätzlich beliebige Querschnitte aufweisen. Vorzugsweise handelt es sich im Rahmen der Erfindung ausschließlich um Vertiefungen, da diese in der Regel mit einem geringeren Aufwand zu realisieren sind.

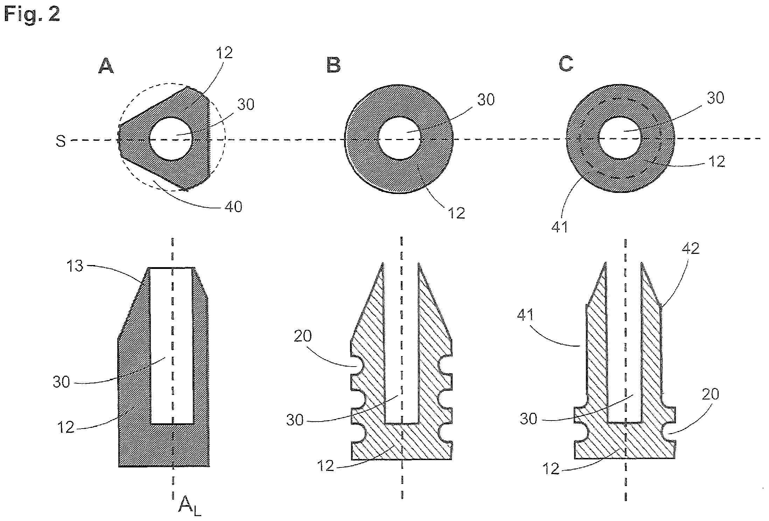

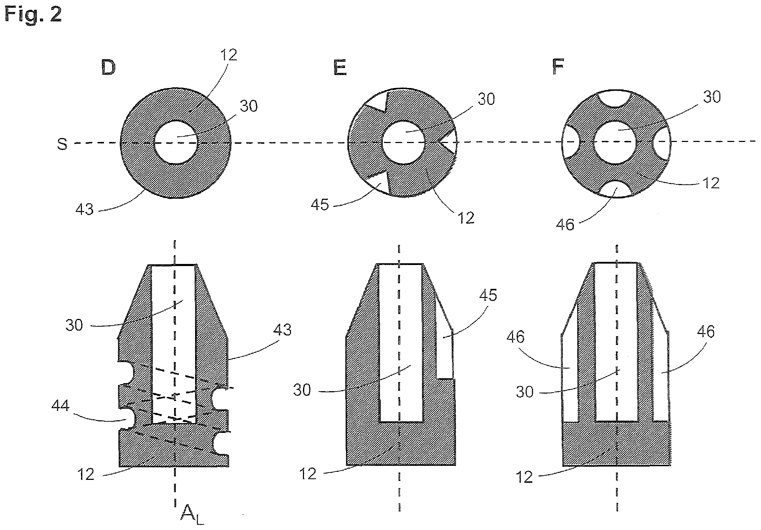

Beispielsweise kann der Querschnitt einer Erhebung oder Vertiefung dreieckig, rechteckig, quadratisch oder halbkreisförmig sein. Grundsätzlich ist für die Ausführbarkeit der Erfindung der Querschnitt, zumindest wenn es sich um Vertiefungen handelt, unerheblich. Linienförmige Vertiefungen oder Erhebungen können beispielsweise ring- oder spiralförmig um die Mantelfläche eines zylindrischen Basis- oder Zwischensegments führen. Alternativ oder zusätzlich können auf der Grundfläche derartige Vertiefungen und/oder Erhebungen angeordnet sein. Entsprechendes gilt beispielsweise für die Mantel- und Grundfläche einer zylinderförmigen Auslassung. Beispiele bevorzugter Ausgestaltungen sind insbesondere auch der Fig. 2 zu entnehmen.

Gemäß einer bevorzugten Ausführungsform weist das Haltesegment eine Vertiefung zur Aufnahme eines Filamentstabes, insbesondere aus Silicium, auf. Dadurch eignet sich die Elektrode beispielsweise besonders für Verfahren zur Abscheidung von Polysilicium. Durch die reduzierte Kontaktfläche und die damit verbundene reduzierte Wärmeableitung vom Haltesegment hin zum Basissegment ist die Elektrode optimal an die zu Beginn der Abscheidung auftretenden geringen Stabdurchmesser angepasst. Das Risiko für ein Umfallen von Polysiliciumstäben während der ersten Phase der Abscheidung (bis das aufwachsende Polysilicium auch den Bereich des Basissegments oder ggf. des Zwischensegments erreicht) wird so auf ein Minimum reduziert. In der Regel kommt es zu gar keinem Umfallen von Stäben mehr.

Das Haltesegment kann ferner eine kegel- oder pyramidenförmige Spitze aufweisen wie in der US 9,150,420 B2 beschrieben. Ferner kann die Elektrode derart ausgeführt sein, dass das Basissegment und/oder ein ggf. vorhandenes Zwischensegmnet die Flanke der Spitze überragen und auf diese Weise einen die Spitze umgebenden Rand ausbilden wie ebenfalls in der US 9,150,420 B2 beschrieben wurde.

Zwischen zwei Segmenten ist zumindest ein Einlegekörper angeordnet. Vorzugsweise ist bei einer 3- oder 4-Segmentelektrode zumindest oder ausschließlich zwischen dem Haltesegment und dem Zwischensegment ein solcher Einlegekörper angeordnet.

Durch den Einlegekörper kann die Wärmeleitfähigkeit zwischen benachbarten Segmenten noch weiter erniedrigt werden. Der Einlegekörper unterbricht vorzugsweise nicht die Kontaktfläche, also den mechanischen Kontakt, zwischen zwei Segmenten komplett, vielmehr führt er eine zusätzliche Verringerung der Kontaktfläche herbei.

Der Einlegekörper kann grundsätzlich eine beliebige Form aufweisen und ist bevorzugt am Boden einer Auslassung angeordnet. Insbesondere kann er entweder dieselbe Querschnittsform aufweisen wie die Auslassung, in welcher er angeordnet ist, oder die Querschnittsform des Segments, das in dieser Auslassung aufgenommen ist. Beispielsweise kann es sich um eine drei-, vier- oder mehreckige Platte (mit oder ohne Durchbrechung(en)), eine Scheibe (mit oder ohne Durchbrechung(en)) oder einen Ring handeln. Es können mehrere Einlegekörper übereinander angeordnet sein.

Ferner kann es sich um mehrere, z.B. kugelförmige Einlegekörper handeln. Der Einlegekörper kann pulverförmig, z.B. als Quarzsand, vorliegen. Auch ist eine netz- bzw. gerüstartige Ausgestaltung möglich. Ferner ist es denkbar, dass der Einlegekörper eine Hülsenform aufweist und so beispielsweise das Basissegment teilweise umgibt.

Der Einlegekörper kann eine Oberfläche mit zumindest einer Vertiefung und/oder Erhebung aufweisen. Gemäß einer bevorzugten Ausführungsform ist der Einlegekörper platten- oder scheibenförmig und hat vorzugsweise auf einer Ober- und/oder Unterseite zumindest eine Vertiefung und/oder Erhebung. Bezüglich der Vertiefung und/oder Erhebung kann auf die obigen Ausführungen verwiesen werden.

Vorzugsweise besteht der Einlegekörper aus einem anderen Material als die Segmente. Während die Segmente insbesondere aus Graphit bestehen, sind bevorzugte Materialien für den Einlegekörper Quarz, Siliciumcarbid, Zirkonoxidkeramiken (mit und ohne Yttriumoxid), Aluminiumoxidkeramiken, Siliciumnitrid, Siliciumnitridkeramiken und CFC. Beim Vorhandensein mehrerer Einlegekörper müssen diese nicht notwendigerweise aus demselben Material bestehen.

Der Einlegekörper muss nicht notwendigerweise elektrisch leitend sein.

Bevorzugt weist der Einlegekörper eine spezifische Wärmeleitfähigkeit von 1 bis 20 W/m*K, besonders bevorzugt 1 bis 12 W/m*K, insbesondere 1 bis 5 W/m*K, auf. Die spezifische Wärmeleitfähigkeit des Einlegeköpers ist vorzugsweise niedriger als die der Segmente.

Der Einlegekörper kann ferner aus einem bezüglich der spezifischen Wärmeleitfähigkeit anisotropen Material bestehen. Insbesondere kann der Einlegekörper in einer Richtung parallel zur Längsachse der Elektrode eine niedrigere spezifische Wärmeleitfähigkeit aufweisen als in einer Richtung senkrecht zur Längsachse (ist der Einlegekörper z.B. eine Scheibe, entspräche dies der radialen Richtung). Beispielseise kann die spezifische Wärmeleitfähigkeit des Einlegekörpers parallel zur Längsachse zwischen 1 und 20 W/m*K, bevorzugt zwischen 1 und 12 W/m*K, besonders bevorzugt zwischen 1 und 5 W/m*K, betragen. Die Wärmeleitfähigkeit senkrecht zur Längsachse kann zwischen 1 und 100 W/m*K, bevorzugt zwischen 1 und 60 W/m*K, besonders bevorzugt zwischen 1 und 20 W/m*K, betragen.

Es ist auch denkbar, dass der Einlegekörper aus mehreren Elementen, beispielsweise koaxial zusammengefügte Scheiben, besteht, die sich hinsichtlich ihrer spezifischen Wärmeleitfähigkeit unterscheiden. Auf diese lässt sich ein Einlegekörper mit einer graduell verlaufenden spezifischen Wärmeleitfähigkeit erzeugen, wobei die spezifische Wärmeleitfähigkeit von innen nach außen zunehmen kann.

Ein weiterer Aspekt der Erfindung ist ein Verfahren zur Herstellung von Polysilicium in einem Reaktor, der zumindest einen durch direkten Stromdurchgang beheizbares Filamentstabpaar aufweist. Das Verfahren umfasst das Einleiten eines Reaktionsgases, enthaltend eine Silicium enthaltende Komponente, insbesondere Trichlorsilan, und Wasserstoff, in den Reaktor, wobei elementares Silicium aus der Gasphase an der Oberfläche des Stabpaars abgeschieden wird. Das Verfahren zeichnet sich dadurch aus, dass das Stabpaar von zwei Elektroden wie sie zuvor beschrieben wurden gehalten und mit Strom versorgt wird.

Im Folgenden wird die erfindungsgemäße Elektrode anhand mehrerer Beispiele näher erläutert. Es zeigen

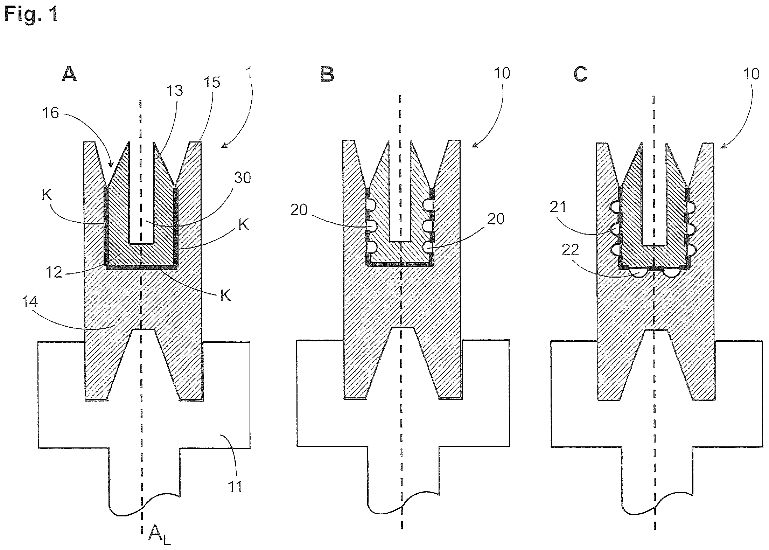

**Fig. 1A**          eine bekannte Elektrode,

**Fig. 1B und 1C**   Elektroden mit Vertiefungen,

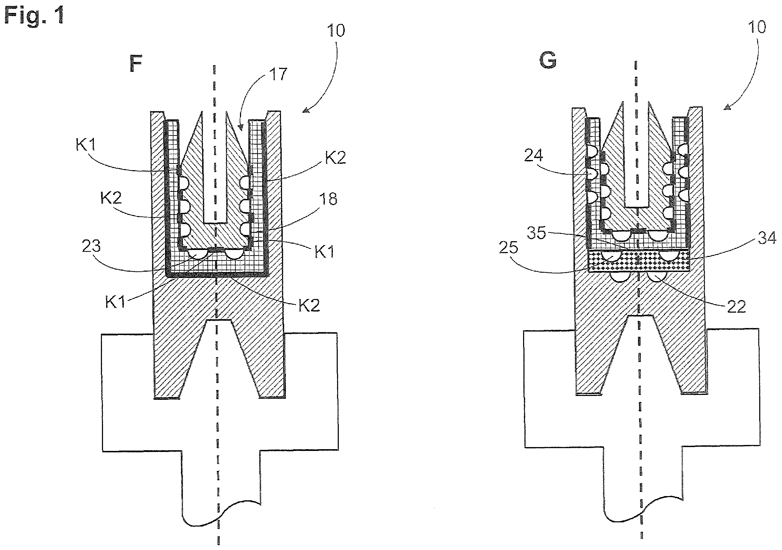

**Fig. 1F**          eine Elektrode mit Zwischensegment,

**Fig. 1D, 1E, 1G**  erfindungsgemäße Elektroden und

**Fig. 2A bis 2E**   Haltesegmente für Elektroden.

**Fig. 1A** zeigt den Längsschnitt einer Elektrode 1 gemäß Stand der Technik. Die Elektrode 1 umfasst ein Basissegment 14, das mit einer Elektrodenhalterung 11 verbunden ist. Die Elektrodenhalterung 11 ist in der Regel in einer Bodenplatte eines Reaktors, beispielsweise Siemens-Reaktor, verankert. Das Basissegment 14 hat im Wesentlichen eine zylindrische Form und weist eine zylindrische Auslassung 16 auf, in welcher ein Haltesegment 12 aufgenommen ist. Basissegment 14 und Haltesegment 12 sind koaxial bezüglich der Elektrodenlängsachse $A_L$ ineinandergesteckt und stehen über eine Kontaktfläche K miteinander in mechanischem Kontakt. Die Kontaktfläche K (breite Linie) bildet sich aus den einander gegenüberliegenden Grenzflächen des Basissegments 14 und des Haltesegments 12, nämlich zum einen aus der Mantel- und Grundfläche des Haltesegments 12 und zum anderen aus der Mantel- und Grundfläche der Auslassung 16. Das Haltesegment 12 weist eine kegelförmige Spitze 13 auf, die von einem abgeschrägten Rand 15 des Basissegments 14 umgeben ist. Ferner hat das Haltesegment 12 eine Aussparung 30 zur Aufnahme eines Filamentstabs (nicht gezeigt).

Sowohl Basissegment 14 als auch Haltesegment 12 bestehen aus hochreinem Graphit, wobei die spezifische Wärmeleitfähigkeit des Haltesegments 12 40 W/m*K beträgt und die des Basissegments 14 100 W/m*K. Die Elektrodenhalterung ist aus einem elektrisch leitfähigen Material, z.B. Metall, gefertigt. Die Elektrode findet insbesondere Anwendung im Siemens-Verfahren zur Herstellung von Polysilicium.

**Fig. 1B** zeigt eine Elektrode 10, die im Aufbau grundsätzlich der Elektrode 1 entspricht. Aus Gründen der Übersichtlichkeit wurde auf eine erneute Kennzeichnung von bereits aus der Fig. 1A bekannten Elementen verzichtet. Im Gegensatz zur Elektrode 1 ist bei der Elektrode 10 die Grenzfläche (Mantelfläche) des Haltesegments 12 mit drei umlaufenden Vertiefungen 20 ausgestattet. Die Vertiefungen 20 weisen jeweils einen halbkreisförmigen Querschnitt auf. Die Vertiefungen 20 unterbrechen die Kontaktfläche K und verkleinern diese somit um etwa 30 %. Dadurch wird eine Wärmeübertragung vom Haltesegment 12 hin zum Basissegment 14 verringert.

**Fig. 1C** zeigt eine Elektrode 10, bei welcher Vertiefungen 21, 22 in die Grenzfläche des Basissegments 14 eingebracht sind. Zum einen weist die die Grenzfläche bildende Mantelfläche der Auslassung 16 drei umlaufende Vertiefungen 21 auf. Zum anderen weist die die Grenzfläche bildende Grundfläche der Auslassung 16 zwei muldenförmige Vertiefungen 22 auf. Die Vertiefungen 22 führen im Gegensatz zur Ausführungsform aus Fig. 1B zu einer zusätzlichen Verringerung der Kontaktfläche K und damit zu einer geringeren Wärmeübertragung zwischen den beiden Segmenten 12, 14.

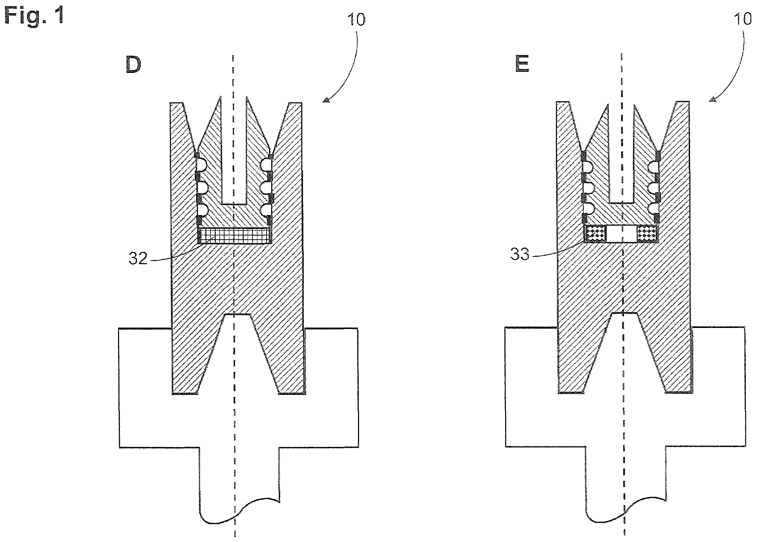

**Fig. 1D** zeigt eine erfindungsgemäße Elektrode 10, die der Elektrode 10 gemäß Fig. 1B entspricht, allerdings mit dem Unterschied, dass zusätzlich ein scheibenförmiger Einlegekörper 32 zwischen Haltesegment 12 und Basissegment 14 angeordnet ist. Die Kontaktfläche K besteht nur aus der Mantelfläche der Auslassung 16 und dem nicht durch die Vertiefungen 20 unterbrochenen Teil der Mantelfläche des Haltesegments 12. Der Einlegekörper 32 besteht aus CFC und weist eine spezifische Wärmeleitfähigkeit von 10 W/m*K auf. Somit vermindert er die Wärmeübertragung zwischen den Segmenten 12, 14 sowohl durch eine Verringerung der Kontaktfläche K als auch durch seine niedrige Wärmeleitfähigkeit.

**Fig. 1E** zeigt eine erfindungsgemäße Elektrode 10, die der Elektrode 10 gemäß Fig. 1D entspricht, allerdings mit dem Unterschied, dass ein ringförmig ausgebildeter Einlegekörper 33 zwischen den Segmenten 12, 14 angeordnet ist. Das Verhältnis zwischen seinem Innen- und Außendurchmesser beträgt 0,4, die spezifische Wärmeleitfähigkeit beträgt 10 W/m*K.

**Fig. 1F** zeigt eine Elektrode 10, die ferner ein Zwischensegment 18 aufweist, das in der Auslassung 16 des Basissegments 14 angeordnet ist. Das Zwischensegment 18 ist im Wesentlichen zylindrisch und weist eine zylindrische Auslassung 17 auf, in welcher das Haltesegment 12 angeordnet ist. Die Segmente 12, 14, 18 sind koaxial bezüglich der Elektrodenlängsachse $A_L$ und stehen über eine Kontaktfläche K1 und eine Kontaktfläche K2 (breite Linien) miteinander in mechanischem Kontakt. Das Zwischensegment 18 besteht aus Elektrographit und hat eine spezifische Wärmeleitfähigkeit von 70 W/m*K.

Die Kontaktfläche K1 bildet sich aus den einander gegenüberliegenden Grenzflächen des Haltesegments 12 und des Zwischensegments 18, nämlich zum einen aus der Mantel- und Grundfläche des Haltesegments 12 und zum anderen aus der Mantel- und Grundfläche der Auslassung 17. Die Kontaktfläche K1 ist einerseits durch die Vertiefungen 20 (vgl. Fig. 1B), andererseits durch eine ringförmige Vertiefung 23 in der Grenzfläche des Zwischensegments 18 unterbrochen und somit um etwa 50 % kleiner als eine Kontaktfläche, die sich ohne das Vorhandensein der Vertiefungen 20, 23 ergeben würde.

Die Kontaktfläche K2 (breite Linie) bildet sich aus den einander gegenüberliegenden Grenzflächen des Basissegments 14 und des Zwischensegments 18, nämlich zum einen aus der Mantel- und Grundfläche des Zwischensegments 18 und zum anderen aus der Mantel- und Grundfläche der Auslassung 16.

Durch die vom Haltesegment 12 (40 W/m*K) über das Zwischensegment 18 (70 W/m*K) hin zum Basissegment 14 (100 W/m*K) schrittweise ansteigende spezifische Wärmeleitfähigkeit in Verbindung mit der unterbrochenen Kontaktfläche K1 ist die Elektrode 10 optimal an eine Zunahme des Durchmessers eines Polysiliciumstabes während des Siemens-Verfahrens angepasst.

**Fig. 1G** zeigt eine erfindungsgemäße Elektrode 10, die sowohl ein Zwischensegment 18 als auch einen Einlegekörper 34 aufweist. Der Einlegekörper 34 ist scheibenförmig, befindet sich zwischen Basissegment 14 und Zwischensegment 18 und ist aus einer Zirkonoxidkeramik mit einer spezifischen Wärmeleitfähigkeit von 3 W/m*K gefertigt. Auf einer Oberfläche 35 weist er eine kreisrunde Vertiefung 25 auf.

Das Zwischensegment 18 hat im Unterschied zur Ausführungsform gemäß Fig. 1F auf seiner Mantelfläche zusätzlich drei umlaufenden Vertiefungen 24, welche die Kontaktfläche K2 ebenso verringern wie der Einlegekörper 34.

Durch die Anwesenheit des Einlegekörpers 34 und der Vertiefungen 24 ist die Wärmeleitfähigkeit der Elektrode 10 in Richtung des Basissegments 14 im Vergleich zur Ausführungsform gemäß Fig. 1F noch weiter verringert. Die muldenförmigen Vertiefungen 22 (vgl. Fig. 1C) des Basissegments 14 tragen zu dieser Verringerung ebenso bei wie die Vertiefung 25.

**Fig. 2A bis 2E** zeigen verschiedene Ausführungsformen von Haltesegmenten 12, wobei die oberen Abbildungen jeweils eine Draufsicht und die unteren Abbildungen jeweils einen Querschnitt entlang der mit S gekennzeichneten Schnittkante darstellen. Das Haltesegment 12 ist ungeachtet vorhandener Vertiefungen jeweils zylindrisch ausgeführt und weist eine kegelförmige Spitze 13 sowie eine Aussparung 30 zur Aufnahme eines Filamentstabes auf.

Das Haltesegment 12 gemäß **Fig. 2A** weist drei Vertiefungen 40 auf. Jede der drei Vertiefungen 40 entspricht einer dem ursprünglich zylindrischen Haltesegment 12 abgenommenen Flanke in Form eines Kreissegments (angedeutet durch die gestrichelte Linie in der oberen Abbildung).

Das Haltesegment 12 gemäß **Fig. 2B** entspricht dem der Fig. 1B.

Bei dem Haltesegment 12 gemäß **Fig. 2C** handelt es sich um eine modifizierte Form der Ausführungsform aus Fig. 2B. Es weist oberhalb einer umlaufenden Vertiefung 20 eine flächige Vertiefung 41 auf. Im Grunde handelt es sich dabei um eine Verjüngung, die beispielsweise durch Drehen realisierbar ist. Die gestrichelte Linie in der oberen Abbildung kennzeichnet die Kante 42 der Vertiefung 41.

Das Haltesegment 12 gemäß **Fig. 2D** hat eine die Mantelfläche 43 spiralförmig umlaufende Vertiefung 44. Die Spiralform ist durch eine gestrichelte Linie angedeutet.

Das Haltesegment 12 gemäß **Fig. 2E** hat drei längs der Elektrodenachse $A_L$ verlaufende Vertiefungen 45 mit einem annähernd dreieckigen Querschnitt.

Das Haltesegment 12 gemäß **Fig. 2F** hat vier längs der Elektrodenachse $A_L$ verlaufende Vertiefungen 46 mit einem annähernd halbkreisförmigen Querschnitt.

**Beispiel**

In einem Siemens-Reaktor wie z.B. in der US 2009/0136408 A1 beschrieben wurden Polysiliciumstäbe mit einem Durchmesser von etwa 180 mm abgeschieden. Dabei wurden die Elektroden gemäß Fig. 1A (Typ 1), 1B (Typ 2), 1D (Typ 3) und 1F (Typ 4) miteinander bezüglich der Anzahl an während der Abscheidung umgefallener Polysiliciumstäbe verglichen. Die Elektroden steckten formschlüssig mit ihrem unteren Ende in einer Auslassung am Kopf der Elektrodenhalterung 11.

Die Länge der Elektrode (ohne Halterung) betrug jeweils etwa 115 mm, ihr Durchmesser betrug etwa 60 mm. Die spezifische Wärmeleitfähigkeit des Haltesegments 12 betrug jeweils 40 W/m*K, die des Basissegments 14 jeweils 100 W/m*K. Die spezifische Wärmeleitfähigkeit des Einlegekörpers 32 der Typ 3 Elektrode betrug 10 W/m*K, die des Zwischensegments 18 der Typ 4 Elektrode 70 W/m*K.

Die Parameter des Abscheideprozesses waren bei allen Versuchen identisch. Die Versuche unterschieden sich nur in der Ausführung der Elektroden. Die Abscheidetemperatur lag während der Abscheidung durchschnittlich zwischen 1000°C und 1100°C. Das Reaktionsgas bestand aus Wasserstoff und Trichlorsilan.

| Elektroden-Typ | Änderung Umfallquote bei dünnem Stabdurchmesser [%] | Änderung Umfallquote bei dickem Stabdurchmesser [%] | Reduzierung Kontaktfläche K bzw. K1 [%] |
|---|---|---|---|
| 1 (Fig. 1A) | 0 | 0 | 0 |
| 2 (Fig. 1B) | -40 | 0 | 30 |
| 3 (Fig. 1D) | -67 | 0 | 70 |
| 4 (Fig. 1F) | -75 | 0 | 50 |

Die Änderung der Umfallquote bei dünnem Stabdurchmesser wurde folgendermaßen ermittelt: Pro Elektrodentyp wurden 500 Chargen abgeschieden. Die Chargen, die bei dünnem Stabdurchmesser (D < 1,5*Elektrodendurchmesser, D < 90 mm) umgefallen sind, wurden gezählt. Elektrodentyp 1 (Fig. 1A) ist die Vergleichselektrode ohne Reduzierung der Kontaktfläche. Auch hier wurde von 500 abgeschiedenen Chargen die Anzahl der mit dünnem Durchmesser umgefallenen Chargen ermittelt. Diese Anzahl wurde auf 100 % normiert. Die Änderung der Umfallquote U bei dünnem Stabdurchmesser des Elektrodentyps x (x = 2, 3 oder 4) bezogen auf die Anzahl der umgefallenen Chargen mit Vergleichselektrode errechnet sich aus:

```
Ux = (( Anzahl umgefallener Chargen Typ x / Anzahl umgefallener
Chargen Typ 1) -1) * 100 %
```

Beispiel:

Anzahl umgefallener Chargen Typ 2: 12
Anzahl umgefallener Chargen Typ 1: 20

$$U2 = (12/20 - 1)*100\% = -40$$

Die Änderung Umfallquote bei dickem Stabdurchmesser wurde folgendermaßen ermittelt: Es wurden mit jedem Elektrodentyp 500 Chargen abgeschieden mit einem Durchmesser > 1,5* Elektrodendurchmesser, also D > 90 mm. Chargen, die bei einem Durchmesser < 1,5*Elektrodendurchmesser ausgefallen oder umgefallen sind, wurden nicht mitgezählt. Von den 500 Chargen jedes Elektrodentyps wurden nur die bei dickem Durchmesser umgefallenen Chargen gezählt. Die Berechnung der Änderung der Umfallquote wurde nach dem gleichen Schema wie oben durchgeführt.

Die Bestimmung der Kontaktfläche erfolgte nach folgender Messmethode: Berechnung der Kontaktfläche anhand der Maße auf den Fertigungszeichnungen der Elektroden. Diese wird in Bezug auf eine angenommene Kontaktfläche der Bauteile der Elektrode ohne Vertiefungen/Erhebungen, d.h. ohne Verringerung der Kontaktfläche genommen.

$$\text{Reduzierung der Kontaktfläche K} = (\text{Kontaktfläche mit}$$
$$\text{Verringerung/Kontaktfläche ohne Verringerung} - 1)*100\%$$

**Patentansprüche**

1. Elektrode (10), umfassend ein Haltesegment (12), ein Basissegment (14), das eine Auslassung (16) aufweist, in welcher das Haltesegment (12) aufgenommen ist, und optional mindestens ein Zwischensegment (18), das zwischen dem Basissegment (14) und dem Haltesegment (12) angeordnet ist, wobei sich zumindest zwei der Segmente (12, 14, 18) hinsichtlich ihrer spezifischen Wärmeleitfähigkeit unterscheiden, wobei das Haltesegment (12) die niedrigste und das Basissegment (14) die höchste spezifische Wärmeleitfähigkeit aufweist, und wobei benachbarte Segmente einander gegenüberliegende Grenzflächen aufweisen, die zumindest teilweise mechanisch miteinander in Kontakt stehen und so eine Kontaktfläche (K, K1, K2) ausbilden, **dadurch gekennzeichnet, dass** zur Verringerung der Kontaktfläche (K, K1, K2) zumindest eine der Grenzflächen mindestens eine Vertiefung (20, 21, 22, 23, 24) und/oder Erhebung aufweist und zwischen zwei Segmenten (12, 14, 18) zumindest ein Einlegekörper (32, 33, 34) angeordnet ist.

2. Elektrode nach Anspruch 1, **dadurch gekennzeichnet, dass** zumindest oder ausschließlich die Grenzfläche des Haltesegments (12) mindestens eine Vertiefung (20) und/oder Erhebung aufweist.

3. Elektrode nach Anspruch 1 oder 2, **dadurch gekennzeichnet, dass** das Haltesegment eine Aussparung (30) zur Aufnahme eines Filamentstabes aufweist.

4. Elektrode nach einem der vorhergehenden Ansprüche, **dadurch gekennzeichnet, dass** die Vertiefungen (20, 21, 22, 23, 24, 25) und/oder Erhebungen punktförmig und/oder linienförmig ausgebildet sind.

5. Elektrode nach einem der vorhergehenden Ansprüche, **dadurch gekennzeichnet, dass** die Segmente (12, 14, 18) aus Graphit bestehen.

6. Elektrode nach einem der vorhergehenden Ansprüche, **dadurch gekennzeichnet, dass** der Einlegekörper (32, 33, 34) mindestens eine Oberfläche (35) mit zumindest einer Vertiefung (25) und/oder Erhebung aufweist.

7. Elektrode nach einem der vorhergehenden Ansprüche, **dadurch gekennzeichnet, dass** der Einlegekörper (32, 33, 34) aus einem anderen Material besteht als die Segmente (12, 14, 18) .

8. Elektrode nach einem der vorhergehenden Ansprüche, **dadurch gekennzeichnet, dass** der Einlegekörper (32, 33, 34) aus einem Material ausgewählt aus der Gruppe mit Quarz, Siliciumcarbid, Siliciumnitrid, Siliciumnitridkeramiken, Zirkonoxidkeramiken, Aluminiumoxidkeramiken und Kohlenstofffaserverstärkte Kohlenstoffe besteht.

9. Elektrode nach einem der vorhergehenden Ansprüche, **dadurch gekennzeichnet, dass** der Einlegekörper (32, 33, 34) eine spezifische Wärmeleitfähigkeit von 1 bis 20 W/ m*K, bevorzugt 1 bis 12 W/m*K, besonders bevorzugt 1 bis 5 W/m*K, aufweist.

10. Elektrode nach einem der vorhergehenden Ansprüche, **dadurch gekennzeichnet, dass** der Einlegekörper (32, 33, 34) aus einem bezüglich der spezifischen Wärmeleitfähigkeit anisotropen Material besteht.

11. Verfahren zur Herstellung von polykristallinem Silicium in einem Reaktor, der zumindest einen durch direkten Stromdurchgang beheizbares Filamentstabpaar aufweist, umfassend Einleiten eines Reaktionsgases, enthaltend eine Silicium enthaltende Komponente und Wasserstoff, in den Reaktor, wobei elementares Silicium aus der Gasphase an der Oberfläche des Filamentstabpaars abgeschieden wird, **dadurch gekennzeichnet, dass** das Filamentstabpaar von zwei Elektroden 10 gemäß einem oder mehreren der Ansprüche 1 bis 10 gehalten und mit Strom versorgt wird.

**Claims**

1. Electrode (10) comprising a holder segment (12), a base segment (14) having a cutout (16) in which the holder segment (12) is accommodated and optionally at least one intermediate segment (18) arranged between the base segment (14) and the holder segment (12), wherein at least two of the segments (12, 14, 18) differ in respect of their specific thermal conductivity, wherein the holder segment (12) has the lowest and the base segment (14) the highest specific thermal conductivity and wherein adjacent segments have opposing interfaces which are at least partially in mechanical contact with one another and thus form a contact area (K, K1, K2), **characterized in that** to reduce the contact area (K, K1, K2) at least one of the interfaces has at least one depression (20, 21, 22, 23, 24) and/or elevation and at least one insert (32, 33, 34) is arranged between two segments (12, 14, 18).

2. Electrode according to Claim 1, **characterized in that** at least or exclusively the interface of the holder segment (12) has at least one depression (20) and/or elevation.

3. Electrode according to Claim 1 or 2, **characterized in that** the holder segment has a recess (30) for accommodating a filament rod.

4. Electrode according to any of the preceding claims, **characterized in that** the depressions (20, 21, 22, 23, 24, 25) and/or elevations are punctate and/or linear.

5. Electrode according to any of the preceding claims, **characterized in that** the segments (12, 14, 18) are made of graphite.

6. Electrode according to any of the preceding claims, **characterized in that** the insert (32, 33, 34) has at least one surface (35) having at least one depression (25) and/or elevation.

7. Electrode according to any of the preceding claims, **characterized in that** the insert (32, 33, 34) is made of a different material to the segments (12, 14, 18).

8. Electrode according to any of the preceding claims, **characterized in that** the insert (32, 33, 34) is made of a material selected from the group comprising quartz, silicon carbide, silicon nitride, silicon nitride ceramics, zirconium oxide ceramics, aluminium oxide ceramics and carbon fibre-reinforced carbons.

9. Electrode according to any of the preceding claims, **characterized in that** the insert (32, 33, 34) has a specific thermal conductivity of 1 to 20 W/ m*K, preferably 1 to 12 W/ m*K, particularly preferably 1 to 5 W/m*K.

10. Electrode according to any of the preceding claims, **characterized in that** the insert (32, 33, 34) is made of a material which is anisotropic in respect of the specific thermal conductivity.

11. Process for producing polycrystalline silicon in a reactor comprising at least one filament rod pair heatable by direct passage of current, comprising introducing a reaction gas containing a silicon-containing component and hydrogen into the reactor, wherein elemental silicon from the gas phase is deposited at the surface of the filament rod pair, **characterized in that** the filament rod pair is held and supplied with current by two electrodes 10 according to one or more of claims 1 to 10.

**Revendications**

1. Électrode (10) comprenant un segment de retenue (12), un segment de base (14) qui comporte une ouverture (16) dans laquelle le segment de retenue (12) est reçu, et éventuellement au moins un segment intermédiaire (18) qui est disposé entre le segment de base (14) et le segment de retenue (12), au moins deux des segments (12, 14, 18) diffèrent par leur conductivité thermique spécifique, le segment de retenue (12) ayant la conductivité thermique spécifique la plus faible et le segment de base (14) ayant la conductivité thermique spécifique la plus élevée, et des segments adjacents comportant des surfaces de limites opposées les unes aux autres qui sont au moins partiellement en contact mécanique les unes avec les autres et qui forment ainsi une surface de contact (K, KI, K2), **caractérisé en ce que**, pour réduire la surface de contact (K, KI, K2), au moins une des surfaces limite comporte au moins une dépression (20, 21, 22, 23, 24) et/ou une élévation et au moins un corps d'insertion (32, 33, 34) est disposé entre deux segments (12, 14, 18).

2. Électrode selon la revendication 1, **caractérisée en ce qu'**au moins ou exclusivement la surface limite du segment de retenue (12) comporte au moins une dépression (20) et/ou une élévation.

3. Électrode selon la revendication 1 ou 2, **caractérisée en ce que** le segment de retenue comporte un évidement (30) destiné à recevoir une tige filamentaire.

4. Électrode selon l'une des revendications précédentes, **caractérisée en ce que** les dépressions (20, 21, 22, 23, 24, 25) et/ou les élévations sont réalisées sous la forme de points et/ou lignes.

5. Électrode selon l'une des revendications précédentes, **caractérisée en ce que** les segments (12, 14, 18) sont en graphite.

6. Électrode selon l'une des revendications précédentes, **caractérisée en ce que** le corps d'insertion (32, 33, 34) comporte au moins une surface (35) pourvue d'au moins une dépression (25) et/ou d'une élévation.

7. Électrode selon l'une des revendications précédentes, **caractérisée en ce que** le corps d'insertion (32, 33, 34) est en un matériau différent de celui des segments (12, 14, 18).

8. Électrode selon l'une des revendications précédentes, **caractérisée en ce que** le corps d'insertion {32, 33, 34) est en un matériau choisi dans le groupe comprenant le quartz, le carbure de silicium, le nitrure de silicium, les céramiques au nitrure de silicium, les céramiques à l'oxyde de zirconium, les céramiques à l'oxyde d'aluminium et les carbones renforcés de fibres de carbone.

9. Électrode selon l'une des revendications précédentes, **caractérisée en ce que** le corps d'insertion (32, 33, 34) a une conductivité thermique spécifique allant de 1 à 20 W/m*K, de préférence de 1 à 12 W/m*K, de manière particulièrement préférée de 1 à 5 W/m*K.

10. Électrode selon l'une des revendications précédentes, **caractérisée en ce que** le corps d'insertion (32, 33, 34) est en un matériau anisotrope quant à la conductivité thermique spécifique.

11. Procédé de production de silicium polycristallin dans un réacteur qui comporte au moins une paire de tiges filamentaires pouvant être chauffées par passage de courant continu, ledit procédé comprenant l'introduction d'un gaz de réaction contenant un composant contenant du silicium et de l'hydrogène dans le réacteur, du silicium élémentaire étant déposé à partir de la phase gazeuse sur la surface de la paire de tiges filamentaires, **caractérisé en ce que** la paire de tiges de filament est maintenue et alimentée en courant par deux électrodes 10 selon une ou plusieurs des revendications 1 à 10.

Fig. 1

Fig. 1

Fig. 1

Fig. 2

EP 3 830 030 B1

Fig. 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20090136408 A1
- US 6639192 B2
- US 9150420 B2
- US 8366892 B2
- WO 2010133386 A1
- DE 202013104065 U1
- WO 2016073014 A1
- CN 204938991 U